# EUROPÄISCHE PATENTSCHRIFT

(11) **EP 3 256 539 B1**
(45) Veröffentlichungstag und Bekanntmachung des Hinweises auf die Patenterteilung: **08.04.2020**
(21) Anmeldenummer: 16702572.5
(22) Anmeldetag: 03.02.2016
(51) Int. Cl.: C09J 7/21, D06H 7/00, D06H 7/22, B23K 20/10, B23K 103/00

(54) **VERFAHREN ZUM KONFEKTIONIEREN VON TEXTILEN KLEBEBÄNDERN**
METHOD FOR PRODUCING TEXTILE ADHESIVE TAPE
PROCÉDÉ DE FABRICATION DE BANDES TEXTILES ADHÉSIVES

(30) Priorität: 13.02.2015 DE 102015102104
(43) Veröffentlichungstag der Anmeldung: 20.12.2017
(73) Patentinhaber: Coroplast Fritz Müller GmbH & Co. KG, 42279 Wuppertal (DE)
(72) Erfinder: LODDE, Christoph, 59439 Holzwickede (DE); WITTIG, Gülay, 44799 Bochum (DE); ZAKRZOWSKI, Thomas, 42399 Wuppertal (DE); BECKER, Klaus, 45549 Sprockhövel (DE)
(74) Vertreter: Patent- und Rechtsanwälte Dr. Solf & Zapf
(86) Internationale Anmeldenummer: PCT/EP2016/052242
(87) Internationale Veröffentlichungsnummer: WO 2016/128268

(56) Entgegenhaltungen:
- EP-A1- 2 821 453
- EP-A1- 2 824 153
- EP-A2- 0 267 604
- CH-A2- 702 818
- DE-A1-102011 005 200
- DE-U1-202011 110 445
- US-A1- 2010 048 074
- Ineta Vilumsone-Nemes: "Industrial Cutting of Textile Materials" In: "Woodhead Publishing Series in Textiles Ser.", 19 April 2012 (2012-04-19), Elsevier Science & Technology, XP055493619, ISBN: 978-0-85709-134-5 pages 104-127, * page 121 - page 124 *

## Beschreibung

Die vorliegende Erfindung betrifft ein Verfahren zum Konfektionieren von textilen Klebebändern, gemäß dem Oberbegriff des Anspruchs 1.
Des Weiteren bezieht sich die vorliegende Erfindung auf ein Klebeband, gemäß dem Oberbegriff des Anspruchs 6.
Für das gattungsgemäße Verfahren sind folgende Konfektionier-Verfahren bekannt.
1. Das Abstechen der Rollen von der Mutterrolle, die sogenannte Abstech-Konfektionierung,
2. das Rollenschneiden mit Rasierklingenschnitt, wobei ein feststehendes Messer verwendet wird,
3. das Rollenschneiden mit einem Quetschmesser (Rundmesser) und einer hierzu vorhandenen Gegenwelle,
4. das Rollenschneiden mit einem feinen und groben Zickzack-Schnitt,
5. das Rollenschneiden mit Rundmessern, die eine unterschiedliche Perforation haben und
6. das Rollenschneiden mit einem sogenannten Scherenschnitt.

Alle die vorgenannten Konfektionierungsverfahren haben den Nachteil, dass bei Geweben oder Vliesen mit Fadenverstärkungen es zu Ausfransungen, Fadenbildung und Fusselbildung an den jeweiligen Bandrändern kommen kann. Dies führt in der Regel zu Kundenreklamationen, da die Kabelsätze, die mit einem derartigen Klebeband umwickelt sind, optisch nicht gut aussehen, und der Verarbeitungsprozess beim Kabelsatzkonfektionär gestört wird.

Der vorliegenden Erfindung liegt die Aufgabe zu Grunde, die vorstehenden Nachteile zu vermeiden und ein Verfahren bereit zu stellen, mit dem Klebebänder mit einer glatten Schnittkante ohne Ausfransungen, Fadenbildung oder Fusselbildung hergestellt werden können.

Des Weiteren liegt der vorliegenden Erfindung die Aufgabe zu Grunde, ein Klebeband zur Verfügung zu stellen, das glatte Schnittkanten aufweist, so dass keine Fadenbildung und Fusselbildung an den Kanten vorhanden ist.

Erfindungsgemäß wird dies durch die Merkmale des Anspruchs 1 erreicht.

Die erfindungsgemäße Kühlung bewirkt insbesondere eine Kühlung der Schnittkanten des mit der Klebeschicht versehenen Bandmaterials.

Das Ultraschall-Schneiden von textilen Materialien ist an sich bekannt. Hierbei werden die textilen Gewebe präzise mit Hilfe der Ultraschall-Schwingungen geteilt. Das Ultraschall-Schneiden ist auf Grund der reduzierten erforderlichen Kräfte durch das Schwingen des Schneidwerkzeugs leichter als mit herkömmlichen Messern. Hierbei findet keine Deformation durch Verdrücken oder Quetschen der Trägermaterialien statt. Durch das Ultraschall-Schneiden werden die textilen Materialien an ihren Rändern versiegelt, so dass an den Schnittkanten keine Ausfransungen und keine Fusselbildung erfolgen können.

Die vorliegende Erfindung basiert auf der Erkenntnis, dass durch die Kühlung des Schneidbereichs und des Schneidwerkzeugs verhindert wird, dass die Klebeschicht aufschmelzen kann, und ein Klebefilm sich ausbildet, wodurch das Ultraschall-Schneiden blockiert wird und die verwendeten Messer verschmutzen. Ein derartiger flüssiger Trennfilm würde eine saubere Trennung der Materialien verhindern.

Erfindungsgemäß ist es zum Durchführen des erfindungsgemäßen Verfahrens weiterhin von Vorteil, wenn zum Ultraschall-Schneiden eine Sonotrode und ein dieser gegenüberliegendes Schneidrad als Schneidwerkzeug verwendet werden, wobei das Klebeband zwischen diesen verläuft und die Sonotrode und das Schneidrad während des Schneidvorgangs derart gekühlt werden, dass die Bildung eines flüssigen Trennfilms durch Aufschmelzen der Klebebeschichtung verhindert wird. Die Kühltemperatur insbesondere auch für die Sonotrode und/oder das Schneidrad beträgt z. B. 10 °C. Abweichungen von ± 20 % hiervon sind ebenfalls möglich.

Bei dem erfindungsgemäßen Verfahren werden die Materialkanten miteinander verschweißt und gleichzeitig wird verhindert, dass der Kleber der Klebeschicht sich ebenfalls an der Schneidkante ausbreiten kann, da ein Aufschmelzen der Klebeschicht durch die erfindungsgemäße Kühlung im Kantenbereich vermieden wird.

Weiterhin ist erfindungsgemäß vorgesehen, dass das Ultraschall-Schneiden unter einem Schneidwinkel von 90 ° bis 145 ° erfolgt. Dieser erfindungsgemäße Schneidwinkelbereich begünstigt die Verhinderung der Trennfilmbildung und ein sauberes Verschweißen an den Kanten des Trägermaterials.

Das Ultraschall-Schneiden bei der Konfektionierung von textilen Klebebändern, insbesondere von Klebebändern für die Umwicklung von Kabelsätzen, d. h. sogenannten Kabelwickelbändern, bietet folgende Vorteile:
- Schnelle und variable Schnitte,
- saubere Materialtrennung mit versiegelten Schnittkanten, wobei das Schneiden und die Kantenversiegelung in einem Prozess erfolgen,
- hohe Schnittgeschwindigkeiten, z. B. 25 m/min
- reduzierte Stillstandzeiten für die Reinigung,
- flusenfreie, feste, versiegelte Kanten,
- umweltfreundliche Technologie,
- geringer Energiebedarf und somit schnelle Taktzeiten,
- ein kontinuierliches Schneidverfahren bei der Verwendung der Roll-Sonotrode.

Grundsätzlich ist das erfindungsgemäße Verfahren für alle üblichen textilen Trägermaterialien verwendbar. Erfindungsgemäß wird aber insbesondere das Verfahren verwendet für das Schneiden von PA-Gewebe, PET-Gewebe, PET-Nähvlies oder PET-Nadelvlies. Weiterhin wird erfindungsgemäß zur Herstellung und Konfektionierung der Klebebänder als Klebebeschichtung insbesondere ein Acrylat-Kleber, insbesondere ein Polyacrylatkleber, oder ein Synthesekautschuk-Kleber verwendet.

Weiterhin bezieht sich die Erfindung auf ein Klebeband, gemäß den Merkmalen des Anspruchs 6.
Weitere vorteilhafte Ausführungen der Erfindung sind in den Unteransprüchen enthalten.

Im Folgenden wird die Erfindung an Hand von Ausführungsbeispielen näher erläutert. Es zeigen:
- Fig. 1: eine Ansicht einer bei dem erfindungsgemäßen Verfahren verwendeten Schneideinrichtung,
- Fig. 2: einen Schnitt durch ein Schneidrad eines erfindungsgemäß verwendeten Schneidwerkzeuges und
- Fig. 3: eine Ansicht eines erfindungsgemäße hergestellten Klebebandes im Querschnitt.

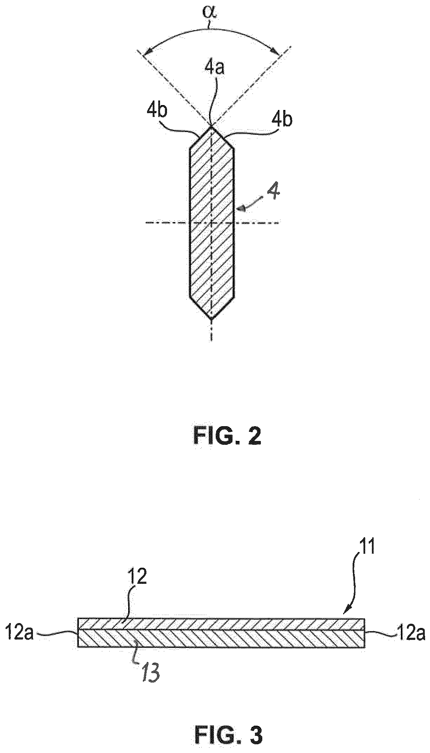

Bei einem erfindungsgemäßen Verfahren zum Konfektionieren von textilen Klebebändern 11, siehe Fig. 3, insbesondere Kabelwickelbändern, werden aus einer Klebeband-Mutterrolle mit einer einseitig aufgebrachten Klebebeschichtung 12 durch Schneiden in Abzugsrichtung Z der Mutterrolle aus dieser mehrere streifenförmige Klebebänder mit jeweils zwei randseitigen Schnittkanten 12a erzeugt, wobei das Schneiden mittels Ultraschall erfolgt. Hierbei wird ein ultraschallerregtes Schneidwerkzeug verwendet, und das Ultraschall-Schneiden erfolgt unter gleichzeitiger Kühlung des Schneidbereiches und des Schneidwerkzeugs.

Hierbei beträgt eine Vorschubgeschwindigkeit 25 m/min, mit der die Mutterrolle abgezogen wird.

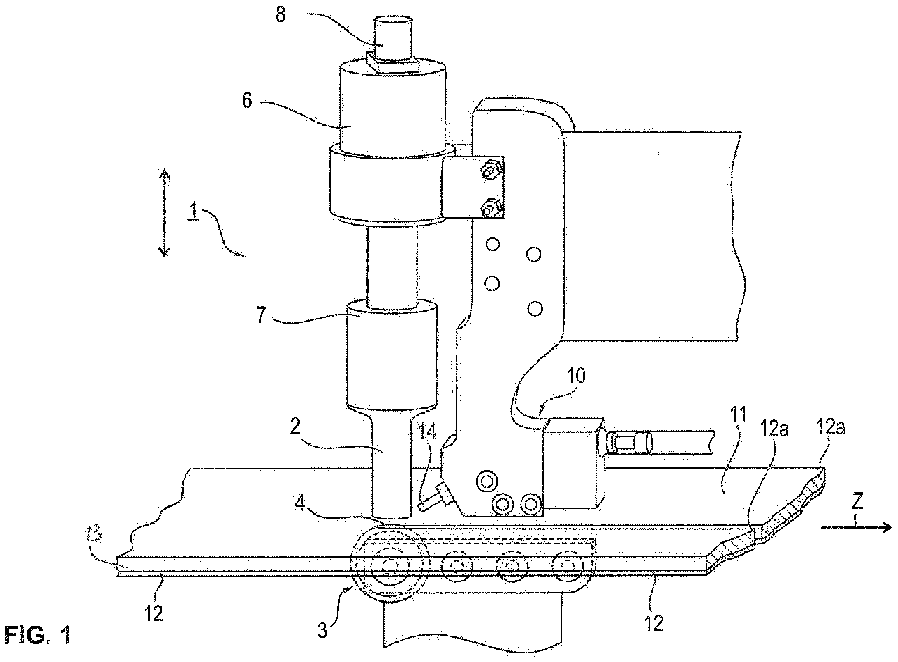

In Fig. 1 ist ein Ausführungsbeispiel eines erfindungsgemäß verwendeten Ultraschall-Schneidwerkzeugs dargestellt. Bei diesem Ausführungsbeispiel besteht das Schneidwerkzeug 1 aus einer Sonotrode 2 und einer dieser gegenüberliegend angeordneten Schneideinrichtung 3, wobei diese Schneideinrichtung 3 ein Schneidrad 4 aufweist. Hierbei transferiert die Sonotrode 2 den Schall durch das zu schneidende Substrat, im vorliegenden Fall das mit einer Klebeschicht 12 versehene textile Trägermaterial 13 einer Klebeband-Mutterrolle auf das gegenüberliegende Schneidrad 4. Hierbei hat das Schneidrad 4 die Funktion, das Material zu trennen und die Schneidkanten 12a jeweils zu verschmelzen bzw. zu versiegeln, wobei das beschichtete Band zwischen dem Schneidrad 4 und der Sonotrode 2 verläuft, wie in Fig. 1 dargestellt. Das Schneidrad 4 wird in seiner Geometrie dem gewünschten Schneidresultat entsprechend angepasst. Weiterhin weist das Ultraschallsystem des Schneidwerkzeugs 1 einen Ultraschall-Generator auf, der nicht dargestellt ist, der über eine entsprechende Leitung mit einem Ultraschall-Konverter 6 verbunden ist, an dem endseitig die Sonotrode 2 angebunden ist. Durch den Ultraschall-Konverter 6 werden elektronisch erzeugte Schwingungen des Generators in mechanische Schwingungen umgewandelt. Diese mechanischen Schwingungen werden über ein Transformationsstück 7 und eine für diesen Anwendungszweck gefertigte Schneid-Sonotrode 2 dem zu schneidenden beschichteten Material zugeführt. In Bruchteilen von Sekunden erzeugen die Ultraschall-Schwingungen einen Schnitt durch das zu schneidende beschichtete Material. Ein üblicher Frequenzbereich einer erfindungsgemäß eingesetzten Sonotrode 2 liegt zwischen 20.000 Hz bis einschließlich 90.000 Hz. Hierbei kann beispielsweise bei einer Schwingungsfrequenz von 30 KHz eine Amplitudenhöhe der Schwingung von 15 µ bis 30 µ erzeugt werden. Erfindungsgemäß können Materialien von 0,05 mm bis 180 mm Dicke geschnitten werden. Die jeweilige Schnittbreite ist abhängig von der Bauform der Sonotrode 2. Eine minimale Breite beträgt 5 mm, und was die maximale Schnittbreite betrifft, so ist diese variabel definierbar.

Erfindungsgemäß ist vorgesehen , wenn ein Schneidwinkel α des verwendeten Schneidrades 4 90 ° bis 145 ° beträgt, siehe Fig. 2. Als Schneidwinkel α gilt der zwischen sich in einer Schneidkante 4a des Schneidrades 4 schneidenden Radseitenflächen 4b eingeschlossene Winkel, siehe Fig. 2. Dabei kann dieser Schneidwinkel α durch ein entsprechendes Schleifen des Schneidrades 4 erzeugt werden. Als textile Trägermaterialien kommen die üblichen Chemiefasern in Frage, wobei die Trägermaterialien z. B. als Gewebe, als Vliese, als Nähvliese oder als Nadelvliese ausgebildet sein können. Vorteilhafterweise besitzen die verwendeten Trägermaterialien ein Flächengewicht zwischen 30 g/m² und 300 g/m². Als Klebemasse für die Klebebeschichtung 12 kommen insbesondere Synthesekautschuke oder Acrylat-, insbesondere Polyacrylat-Klebstoffe zum Einsatz. Dabei ist das Klebstoffauftragsgewicht vorteilhafterweise zwischen 40 g/m² und 200 g/m². Deren Schmelzpunkt reicht von 70 °C bis 250 °C. Bei Synthesekautschukklebern liegt der Schmelzpunkt bei 80 °C bis 160 °C. Das als textiles Faden- und/oder Fasermaterial, z. B. verwendete Polyamid oder Polyamid 6.6 hat einen Schmelzpunkt von > 200 °C oder > 250 °C oder z. B. verwendetes Polyester hat einen Schmelzpunkt von > 210 °C. Oberhalb der angegebenen Schmelzpunkte wird der jeweilige Kunststoff flüssig.

Wie weiterhin aus der Fig. 1 zu erkennen ist, ist es erfindungsgemäß zweckmäßig, dass die Sonotrode 2 mittels einer Kühlungseinrichtung insbesondere durch Luftkühlung im Inneren gekühlt wird, wozu z. B. am Konverter 6 eine entsprechende Anschlusseinheit 8 für das Zuführen von Kühlluft vorhanden ist. Des Weiteren ist es ebenfalls erfindungsgemäß zweckmäßig, dass zusätzlich oder alternativ auch die Schneideinrichtung 3, d. h. das Schneidrad 4, mittels einer Kühlungseinheit 10 gekühlt wird, indem insbesondere durch Luftkühlung in den Schneidbereich Kühlluft durch eine Austrittsdüse 14 zugeführt wird. Durch die Kühlung der Sonotrode 2 und/oder des Schneidrades 4 wird verhindert, dass die Klebebeschichtung 12 des Trägermaterials im Schneidbereich sich verflüssigt und ein Trennfilm erzeugt wird. Damit wird erfindungsgemäß verhindert, dass die Klebebeschichtung 12 sich auch in den Schneidkantenbereich ausdehnen kann, so dass erfindungsgemäß der Schneidkantenbereich, d. h. die Längskante 12a des Klebebandes, frei von Klebemasse der Klebebeschichtung 12 ist. Darüber hinaus wird auf diese Weise insbesondere auch in Verbindung mit dem erfindungsgemäßen Schneidwinkelbereich eine sichere Versiegelung, d. h. Verschmelzung des Trägermaterials im Längskantenbereich, d. h. an der Schneidkante 12a bewirkt. Somit entsteht eine fussel- und fadenfreie Schneidkante, die ebenfalls von Klebstoff frei ist.

In den nachfolgenden Verfahrensbeispielen 1 bis 4 sind beispielhafte Ausführungsbeispiele enthalten.

### Verfahrensbeispiel 1:

Schneiden von Kabelwickelbändern mit PA-Gewebe 185 g/m² mit gekühlter Sonotrode und gekühltem Schneidrad

| Schneidwinkel α | 20 Grad | 45 Grad | 90 Grad | 110 Grad | 120 Grad | 140 Grad | 145 Grad |
|---|---|---|---|---|---|---|---|
| Filmbildung | Stark | Stark | Minimalst/Nein | Nein | Nein | Nein | Minimal |
| Verschweißen der Kante | Nein | Zum Teil | Ja | Ja | Ja | Ja | Ja |
| Fadenbildung | Ja | Ja | Ja | Nein | Nein | Nein | Nein |
| Fusselbildung | Ja | Ja | Ja | Nein | Nein | Nein | Nein |

### Verfahrensbeispiel 2:

Schneiden von Kabelwickelbändern mit PET-Gewebe 130 g/m² mit gekühlter Sonotrode und gekühltem Schneidrad

| Schneidwinkel α | 20 Grad | 45 Grad | 90 Grad | 110 Grad | 120 Grad | 140 Grad | 145 Grad |
|---|---|---|---|---|---|---|---|
| Filmbildung | Stark | Stark | Nein | Nein | Nein | Nein | Minimal |
| Verschweißen der Kante | Nein | Zum Teil | Ja | Ja | Ja | Ja | Ja |
| Fadenbildung | Ja | Ja | Nein | Nein | Nein | Nein | Nein |
| Fusselbildung | Minimalst | Minimalst | Nein | Nein | Nein | Nein | Nein |

### Verfahrensbeispiel 3:

Schneiden von Kabelwickelbändern mit PET-Gewebe 70 g/m² mit gekühlter Sonotrode und gekühltem Schneidrad

| Schneidwinkel α | 20 Grad | 45 Grad | 60 Grad | 90 Grad | 110 Grad | 120 Grad | 140 Grad | 145 Grad |
|---|---|---|---|---|---|---|---|---|
| Filmbildung | Stark | Stark | Minimalst/Nein | Nein | Nein | Nein | Nein | Nein |
| Verschweißen der Kante | Minimalst | Zum Teil | Ja | Ja | Ja | Ja | Ja | Ja |
| Fadenbildung | Ja | Ja | Ja | Nein | Nein | Nein | Nein | Nein |
| Fusselbildung | Ja | Ja | Ja | Nein | Nein | Nein | Nein | Nein |

### Verfahrensbeispiel 4:

Schneiden von Kabelwickelbändern mit PET-Nähvlies 60 g/m² mit gekühlter Sonotrode und gekühltem Schneidrad

| Schneidwinkel α | 20 Grad | 45 Grad | 60 Grad | 90 Grad | 110 Grad | 120 Grad | 140 Grad | 145 Grad |
|---|---|---|---|---|---|---|---|---|
| Filmbildung | Stark | Stark | Minimalst/Nein | Nein | Nein | Nein | Nein | Nein |
| Verschweißen der Kante | Minimalst | Zum Teil | Ja | Ja | Ja | Ja | Ja | Ja |
| Fadenbildung | Ja | Ja | Ja | Nein | Nein | Nein | Nein | Nein |
| Fusselbildung | Ja | Ja | Ja | Nein | Nein | Nein | Nein | Nein |

Entsprechend einem bestimmten Flächengewicht des Trägergewebes ergibt sich, dass erfindungsgemäß der minimale Schneidwinkel 90 ° beträgt und ein maximaler Schneidwinkel 145 °, und zwar bei einer Kühlung der Sonotrode 2 und einer Kühlung des Schneidrades 4. Demnach sind die Ausführungsbeispiele in den Verfahrensbeispielen 1 bis 4 mit einem Schneidwinkel größer/gleich 90 ° erfindungsgemäß.

In den Verfahrensbeispielen 5 bis 7 ist dargestellt, dass entweder bei unterlassener Kühlung der Sonotrode 2 und des Schneidrades 4 oder einer alternativen Kühlung von Sonotrode 2 oder Schneidrad 4 auch bei unterschiedlichen Schneidwinkeln eine schlechte Verschweißung der Schneidkante vorhanden ist und zudem eine Fadenbildung und Fusselbildung nicht verhindert wird.

### Verfahrensbeispiel 5:

Schneiden von Kabelwickelbändern mit PA-Gewebe 185 g/m² ohne Kühlung von Sonotrode und Schneidrad

| Schneidwinkel α | 90 Grad | 110 Grad | 120 Grad |
|---|---|---|---|
| Filmbildung | Sehr stark | Sehr stark | Sehr stark |
| Verschweißen der Kante | Minimalst | Minimalst | Minimalst |
| Fadenbildung | Ja | Nein | Nein |
| Fusselbildung | Ja | Ja | Ja |

### Verfahrensbeispiel 6:

Schneiden von Kabelwickelbändern mit PA-Gewebe 185 g/m² ohne Kühlung von Sonotrode und gekühltem Schneidrad

| Schneidwinkel α | 90 Grad | 110 Grad | 120 Grad |
|---|---|---|---|
| Filmbildung | Sehr stark | Sehr stark | Sehr stark |
| Verschweißen der Kante | Minimalst | Minimalst | Minimalst |
| Fadenbildung | Ja | Ja | Ja |
| Fusselbildung | Ja | Ja | Ja |

### Verfahrensbeispiel 7:

Schneiden von Kabelwickelbändern mit PA-Gewebe 185 g/m² mit Kühlung von Sonotrode und ohne Kühlung Schneidrad

| Schneidwinkel α | 90 Grad | 110 Grad | 120 Grad |
|---|---|---|---|
| Filmbildung | Minimalst | Minimalst | Minimalst |
| Verschweißen der Kante | Ja | Ja | Ja |
| Fadenbildung | Ja | Ja | Ja |
| Fusselbildung | Ja | Nein | Nein |

In der folgenden Tabelle sind beispielhaft, ohne dass hierdurch eine Einschränkung der Erfindung erfolgt, Ausführungsbeispiele für den Gewebeaufbau und die Fasermaterialart sowie die Klebeschicht von erfindungsgemäßen textilen Klebebändern, insbesondere Kabelwickelbändern, aufgeführt.

| | Einheit | PA-Gewebe | PET-Gewebe 130 g/m² | PET-Gewebe 70 g/m² | PET-Gewebe 60 g/m² |
|---|---|---|---|---|---|
| Flächengewicht Träger | g/m² | 185 | 130 | 70 | 60 |
| Faserart | - | Polyamid 6.6 | 100 % Polyester | 100 % Polyester | 100 % Polyester |
| Anzahl der Kettfäden | 1/cm | 20 | 45 | 32 | 20 |
| Garnart Kettfäden | - | Filament, glatt oder texturiert spinn- und/oder stückgefärbt | Filament, intermingelt/texturiert und spinndüsengefärbt | Filament, intermingelt/texturiert und spinndüsengefärbt | Filament, intermingelt/texturiert und spinndüsengefärbt |
| Filamentanzahl Kettfäden | Stück | 68 | 36 | 36 | 24 |
| Fadenstärke der Kettfäden | dtex | 470 | 167 | 84 | 40 |
| Breitenbezogene Kettfädenstärke | dtex/cm | 9400 | 7515 | 2688 | 800 |
| Anzahl der Schussfäden | 1/cm | 16 | 25 | 30 | 30 |
| Garnart Schussfäden | - | Filament, glatt oder texturiert spinn- und/oder stückgefärbt | Filament, intermingelt/texturiert und spinndüsengefärbt | Filament, intermingelt/texturiert und spinndüsengefärbt | Filament, intermingelt/texturiert und spinndüsengefärbt |
| Filamentanzahl Schussfaden | Stück | 68 | 36 | 36 | 36 |
| Fadenstärke der Schussfäden | dtex | 470 | 167 | 167 | 167 |
| Längenbezogene Schussfädenstärke | dtex/cm | 7520 | 4175 | 5010 | 5010 |
| Klebstoff | - | Acrylat Klebstoff | Acrylat Klebstoff | Synthesekautschuk | Acrylat Klebstoff |
| Klebstoffauftragsgewicht | g/m² | 100 | 80 | 50 | 40 |
| Dicke | mm | 0,33-0,35 | 0,24-0,25 | 0,14-0,16 | 0,10-0,12 |
| Reißdehnung | % | 21-35 | 35-40 | 26-38 | 15-18 |
| Bruchkraft | N/cm | 400-1.100 | 200-350 | 80-150 | 50-100 |

### Bezugszeichen

- 1: Schneidwerkzeug
- 2: Sonotrode
- 3: Schneideinrichtung
- 4: Schneidrad
- 4a: Schneidkante von 4
- 4b: Radseitenflächen
- 6: Ultraschall-Konverter
- 7: Transformationsstück
- 8: Anschlusseinheit
- 10: Kühlungseinheit
- 11: textiles Klebeband
- 12: Klebebeschichtung
- 12a: randseitige Schnittkanten
- 13: textiles Trägermaterial
- 14: Austrittsdüse
- α: Schneidwinkel
- Z: Abzugsrichtung der Mutterrolle

## Patentansprüche

1. Verfahren zum Konfektionieren von textilen Klebebändern (11), insbesondere Kabelwickelbändern, wobei aus einer Klebeband-Mutterrolle aus einem textilen Material mit einer einseitig aufgebrachten Klebebeschichtung (12) durch Schneiden in Abzugsrichtung der Mutterrolle aus dieser mehrere streifenförmige Klebebänder (11) mit jeweils zwei randseitigen, Längskanten bildende Schnittkanten (12a) erzeugt werden,
**dadurch gekennzeichnet, dass** das Schneiden mittels Ultraschall erfolgt, wobei ein ultraschallerregtes Schneidwerkzeug (1) verwendet wird und wobei das Ultraschall-Schneiden derart unter gleichzeitiger Kühlung im Schneidbereich und des Schneidwerkzeugs (1) erfolgt, dass ein Aufschmelzen der Klebebeschichtung (12) verhindert wird, wobei das Ultraschall-Schneiden unter einem Schneidwinkel (a) von 90° bis 145° erfolgt.

2. Verfahren nach Anspruch 1,
**dadurch gekennzeichnet, dass** ein aus einer Sonotrode (2) und einem dieser gegenüberliegenden Schneidrad (4) bestehendes Schneidwerkzeug (1) verwendet wird, wobei das Klebeband (11) zwischen diesen verläuft und die Sonotrode (2) und das Schneidrad (4) während des Schneidvorgangs derart gekühlt werden, dass die Bildung eines flüssigen Trennfilms durch Aufschmelzen der Klebebeschichtung verhindert wird.

3. Verfahren nach Anspruch 1 oder 2,
**dadurch gekennzeichnet, dass** als textiles Trägermaterial (13) des Trägers für das Klebeband (11) ein PA-Gewebe, ein PET-Gewebe, ein PET-Nähvlies oder ein PET-Nadelvlies verwendet wird.

4. Verfahren nach Anspruch 2 oder 3,
**dadurch gekennzeichnet, dass** die Klebebeschichtung (12) dem Schneidrad (4) zugekehrt ist.

5. Verfahren nach einem der Ansprüche 1 bis 4,
**dadurch gekennzeichnet, dass** als Kleber für die Herstellung der Klebebeschichtung (12) ein Acrylat-Kleber oder ein Synthesekautschuk-Kleber verwendet werden.

6. Klebeband (11), hergestellt nach einem oder mehreren der Ansprüche 1 bis 5, umfassend einen streifenförmigen textilen Träger und eine einseitig aufgebrachte Klebebeschichtung (12), wobei der Schneidbereich eine Klebebeschichtung aufweist und zwei randseitige, Längskanten bildende Schnittkanten (12a),
**dadurch gekennzeichnet, dass** die Längskanten bildenden Schnittkanten (12a) durch Ultraschall-Schneiden erzeugt sind, wobei das textile Trägermaterial (13) des Trägers an seinen Längskanten bildenden Schnittkanten (12a) verschmolzen ist, und keine Klebebeschichtung (12) an den Längskanten bildenden Schnittkanten (12a) vorhanden ist sowie die Längskanten bildenden Schnittkanten (12a) fussel- und fadenfrei sind.

7. Klebeband (11) nach Anspruch 6,
**dadurch gekennzeichnet, dass** im Bereich der Längskanten bildenden Schnittkanten (12a) eine geringere Banddicke vorhanden ist als im übrigen Randbereich.

8. Klebeband (11) nach Anspruch 6 oder 7,
**dadurch gekennzeichnet, dass** als textiles Trägermaterial (13) des Trägers ein PA-Gewebe, ein PET-Gewebe, ein PET-Nähvlies oder ein PET-Nadelvlies vorhanden ist.

9. Klebeband (11) nach einem der Ansprüche 6 bis 8,
**dadurch gekennzeichnet, dass** die Klebebeschichtung (12) aus einem Acrylat-Kleber oder einem Synthesekautschuk-Kleber besteht.

10. Klebeband (11) nach einem der Ansprüche 6 bis 9,
**dadurch gekennzeichnet, dass** das Trägermaterial (13) des Trägers ein Flächengewicht von 60 g/m² bis 300 g/m² besitzt.

11. Klebeband (11) nach einem der Ansprüche 6 bis 10,
**dadurch gekennzeichnet, dass** der Klebstoff der Klebebeschichtung (12) ein Beschichtungsgewicht von 40 g/m² bis 200 g/m² besitzt.

## Claims

1. Method for converting textile adhesive tapes (11), especially cable wrapping tapes, with a plurality of strip-shaped adhesive tapes (11) each having two marginal cut edges (12a) forming longitudinal edges being produced from a parent roll of adhesive tape composed of a textile material having a single-sidedly applied adhesive coating (12), by cutting in the take-off direction of the parent roll,
**characterized in that** the cutting takes place by means of ultrasound, with an ultrasound-excited cutting tool (1) being used and with the ultrasonic cutting taking place, with simultaneous cooling in the cutting region and of the cutting tool (1), in such a way as to prevent melting of the adhesive coating (12), with the ultrasonic cutting taking place at a cutting angle (α) of 90° to 145°.

2. Method according to Claim 1,
**characterized in that** a cutting tool (1) is used which consists of a sonotrode (2) and of a cutting wheel (4) opposite the latter, with the adhesive tape (11) running between the sonotrode (2) and the cutting wheel (4), which are cooled during the cutting operation in such a way as to prevent the formation of a liquid parting film through melting of the adhesive coating.

3. Method according to Claim 1 or 2,
**characterized in that** textile carrier material (13) of the carrier used for the adhesive tape (11) comprises a woven PA fabric, a woven PET fabric, a stitch-bonded nonwoven PET fabric or a needlefelt PET fabric.

4. Method according to Claim 2 or 3,
**characterized in that** the adhesive coating (12) faces the cutting wheel (4).

5. Method according to any of Claims 1 to 4,
**characterized in that** an acrylate adhesive or a synthetic rubber adhesive is used as adhesive for producing the adhesive coating (12).

6. Adhesive tape (11), produced according to one or more of Claims 1 to 5, comprising a strip-shaped textile carrier and a single-sidedly applied adhesive coating (12), with the cutting region having an adhesive coating, and two marginal cut edges (12a) forming longitudinal edges,
**characterized in that** the cut edges (12a) forming the longitudinal edges are generated by ultrasonic cutting, with the textile carrier material (13) of the carrier being fused at its cut edges (12a) forming the longitudinal edges, and with no adhesive coating (12) being present on the cut edges (12a) forming the longitudinal edges, and with the cut edges (12a) forming the longitudinal edges being lint-free and thread-free.

7. Adhesive tape (11) according to Claim 6,
**characterized in that** the tape thickness in the region of the cut edges (12a) forming the longitudinal edges is lower than in the rest of the marginal region.

8. Adhesive tape (11) according to Claim 6 or 7,
**characterized in that** textile carrier material (13) of the carrier that is present comprises a woven PA fabric, a woven PET fabric, a stitch-bonded nonwoven PET fabric or a needlefelt PET nonwoven fabric.

9. Adhesive tape (11) according to any of Claims 6 to 8,
**characterized in that** the adhesive coating (12) consists of an acrylate adhesive or a synthetic rubber adhesive.

10. Adhesive tape (11) according to any of Claims 6 to 9,
**characterized in that** the carrier material (13) of the carrier possesses a basis weight of 60 g/m² to 300 g/m².

11. Adhesive tape (11) according to any of Claims 6 to 10,
**characterized in that** the adhesive of the adhesive coating (12) possesses a coating weight of 40 g/m² to 200 g/m².

## Revendications

1. Procédé de préparation de bandes adhésives textiles (11), notamment de bandes d'enroulement de câbles, dans lequel, à partir d'un rouleau mère de bande adhésive en un matériau textile comprenant un revêtement adhésif (12) appliqué sur un côté, plusieurs bandes adhésives en forme de ruban (11) sont formées par découpe dans la direction de soutirage du rouleau mère à partir de celui-ci, présentant chacune deux bords de découpe (12a) formant des bords longitudinaux en bordure,
**caractérisé en ce que** la découpe a lieu au moyen d'ultrasons, un outil de découpe à excitation ultrasonore (1) étant utilisé et la découpe par ultrasons ayant lieu avec refroidissement simultané dans la zone de découpe et de l'outil de découpe (1), de telle sorte qu'une fusion du revêtement adhésif (12) soit évitée, la découpe par ultrasons ayant lieu avec un angle de découpe (a) de 90° à 145°.

2. Procédé selon la revendication 1, **caractérisé en ce qu'**un outil de découpe (1) constitué par une sonotrode (2) et une roue de découpe (4) opposée à celle-ci, la bande adhésive (11) passant entre celles-ci, et la sonotrode (2) et la roue de découpe (4) étant refroidies pendant le processus de découpe de telle sorte que la formation d'un film de séparation liquide par fusion du revêtement adhésif soit évitée.

3. Procédé selon la revendication 1 ou 2, **caractérisé en ce qu'**un tissu en PA, un tissu en PET, un non-tissé cousu en PET ou un non-tissé aiguilleté en PET est utilisé en tant que matériau support textile (13) du support pour la bande adhésive (11).

4. Procédé selon la revendication 2 ou 3, **caractérisé en ce que** le revêtement adhésif (12) est orienté vers la roue de découpe (4).

5. Procédé selon l'une quelconque des revendications 1 à 4, **caractérisé en ce qu'**une colle à base d'acrylate ou une colle à base d'un caoutchouc de synthèse est utilisée en tant que colle pour la fabrication du revêtement adhésif (12).

6. Bande adhésive (11), fabriquée selon une ou plusieurs des revendications 1 à 5, comprenant un support textile en forme de ruban et un revêtement adhésif (12) appliqué sur un côté, la zone de découpe comprenant un revêtement adhésif et deux bords de découpe (12a) formant des bords longitudinaux en bordure,
**caractérisée en ce que** les bords de découpe (12a) formant des bords longitudinaux sont formés par découpe par ultrasons, le matériau support textile (13) du support étant fondu au niveau de ses bords de découpe (12a) formant des bords longitudinaux, et aucun revêtement adhésif (12) n'étant présent au niveau des bords de découpe (12a) formant des bords longitudinaux, et les bords de découpe (12a) formant des bords longitudinaux étant exempts de peluches et de fils.

7. Bande adhésive (11) selon la revendication 6,
**caractérisée en ce qu'**une épaisseur de bande plus petite est présente dans la zone des bords de découpe (12a) formant des bords longitudinaux que dans la zone de bordure restante.

8. Bande adhésive (11) selon la revendication 6 ou 7,
**caractérisée en ce qu'**un tissu en PA, un tissu en PET, un non-tissé cousu en PET ou un non-tissé aiguilleté en PET est présent en tant que matériau support textile (13) du support.

9. Bande adhésive (11) selon l'une quelconque des revendications 6 à 8, **caractérisée en ce que** le revêtement adhésif (12) est constitué par une colle à base d'acrylate ou une colle à base de caoutchouc synthétique.

10. Bande adhésive (11) selon l'une quelconque des revendications 6 à 9, **caractérisée en ce que** le matériau support (13) du support présente un poids surfacique de 60 g/m² à 300 g/m².

11. Bande adhésive (11) selon l'une quelconque des revendications 6 à 10, **caractérisée en ce que** l'adhésif du revêtement adhésif (12) présente un poids de revêtement de 40 g/m² à 200 g/m².
